# EUROPÄISCHE PATENTSCHRIFT

(11) **EP 1 176 610 B1**
(45) Veröffentlichungstag und Bekanntmachung des Hinweises auf die Patenterteilung: **11.02.2004**
(21) Anmeldenummer: 01810599.9
(22) Anmeldetag: 19.06.2001
(51) Int. Cl.: H01B 1/12, H01B 1/20, H05K 9/00, H01B 1/22, H01B 1/24, D02G 3/12

(54) **Feindraht Bzw. Feinstdraht für die Anwendung in einem Fasermaterial sowie Anwendung eines solchen Feindrahtes Zbw. Feinstdrahtes**
Fine wire or superfine wire for use in fibrous material as application of such a fine wire or superfine wire
Fil fin ou superfin utilisé dans un matériau fibreux ainsi que l'utilisation d'un tel fil fin ou superfin

(30) Priorität: 25.07.2000 CH 146800
(43) Veröffentlichungstag der Anmeldung: 30.01.2002
(73) Patentinhaber: Elektro-Feindraht AG, 6182 Escholzmatt (CH)
(72) Erfinder: Dürr, Herbert, 6182 Escholzmatt (CH); Bucher, Kurt, 6182 Escholzmatt (CH); Zemp, Benno, 6170 Schüpfheim (CH)
(74) Vertreter: Isler & Pedrazzini AG

(56) Entgegenhaltungen:
- EP-A- 0 275 171
- EP-A- 0 525 925
- EP-A- 0 816 543
- EP-A- 0 828 345
- WO-A-91/05979
- DE-A- 3 438 660
- DE-A- 19 524 526
- US-A- 4 975 317
- US-A- 5 416 155
- US-A- 5 556 697
- US-A- 5 563 182

## Beschreibung

### TECHNISCHES GEBIET

Die vorliegende Erfindung bezieht sich auf das Gebiet der Technik von elektrisch leitenden Drähten. Sie betrifft einen Feindraht bzw. Feinstdraht gemäss dem Oberbegriff des Anspruchs 1 sowie die Anwendung eines solchen Fein- bzw. Feinstdrahtes.

Ein solcher Feindraht und seine Anwendung ist z.B. aus der Druckschrift EP-A2-0 816 543 bekannt.

### STAND DER TECHNIK

Im Zuge der zunehmenden Verwendung und Verteilung von elektrischer Energie sowie der schnellen Verbreitung der drahtlosen Informationsübertragung, insbesondere auch im Rahmen der Mobiltelephonie, wächst die Sensibilität der Menschen gegenüber dem sogenannten Elektrosmog, d.h. der Summe der elektromagnetischen Gleich- und Wechselfelder unterschiedlichster Frequenz. Darüber hinaus bestehen aber auch objektive technische Notwendigkeiten, Bauteile, Geräte oder ganze Räume unter bestimmten Bedingungen gegen elektromagnetische Störfelder (EMI) abzuschirmen.

Zur elektromagnetischen Abschirmung eignen sich üblicherweise Metallgehäuse oder Metallfolien, aber auch metallische Beschichtungen, die auf an sich nichtleitende Flächen aufgebracht werden. Der Einsatz solcher Abschirmmaterialien hat sich bewährt, ist allerdings hinsichtlich der Flexibilität gewissen Einschränkungen unterworfen. Es ist daher wünschenswert, ein Abschirmmaterial zur Verfügung zu haben, das leicht beweglich und veränderbar ist wie ein Stoff, und beispielsweise als Gardine oder Beutel, oder aber als Kleidungsstück oder in einem Kleidungsstück, Abschirmaufgaben erfüllen kann.

Es ist daher bereits vorgeschlagen worden (US-A-4,975,317), elektrisch leitende Gewebe dadurch zu erzeugen, dass man entweder die einzelnen Fasern oder Game eines textilen Gewebes vor dem Weben mit einer elektrischen leitenden Schicht überzieht, oder das fertige Gewebe insgesamt mit einer solchen Beschichtung versieht. Die elektrisch leitende Beschichtung wird dabei vorzugsweise durch chemische Oxidation in einer wässrigen Lösung mit einem kohärenten, ausgerichteten Film eines elektrisch leitenden organischen Polymers aus der Gruppe der Pyrrol-Polymere und Anilin-Polymere erzeugt. Nachteilig ist bei dieser Art von elektrisch leitendem Gewebe, dass die Fasern bzw. das Gewebe selbst elektrisch nicht leitend sind und die leitende organische Beschichtung alleine nicht ausreicht, um beim fertigen Gewebe insgesamt einen sehr niedrigen elektrischen Widerstand und damit eine "quasi-metallische" Abschirmwirkung zu erzielen.

In derselben Druckschrift wird in der Einleitung aber auch darauf hingewiesen, dass es möglich und bekannt ist, die für das Garn bzw. zum Weben verwendeten Fasern aus einer mit leitendem Pulver vermischten Polymerschmelze zu extrudieren und so direkt elektrisch leitende Fasern zu erhalten. Nachteilig ist dabei, dass sich durch den Zusatz der elektrisch leitenden Füllstoffe die mechanischen Eigenschaften der Fasern deutlich verschlechtern, und zwar um so mehr, je höher der Anteil der Zusätze und je besser dadurch die elektrische Leitfähigkeit ist.

Eine andere bekannte Möglichkeit besteht darin, direkt aus feinen, blanken Metalldrähten ein Gewebe herzustellen, das beispielsweise als flexible Abschirmdichtung zwischen zwei aneinanderstossenden Dichtungsflächen eingesetzt werden kann (siehe dazu die EP-A2-0 275 171). Ein solches Gewebe aus blanken Drähten ist jedoch durch die Umwelteinflüsse der Korrosion ausgesetzt. Um eine mit der Korrosion einhergehende Verschlechterung der elektrischen Leitfähigkeit zu verhindern, muss das Gewebe zum Schutz in ein Gelmaterial eingebettet werden, wodurch der Anwendungsbereich erheblich eingeschränkt wird. Darüber hinaus ist es für den Einsatz im Textilbereich nachteilig, dass wegen der Verwendung der blanken Metalldrähte nur wenig Farben für das fertige Gewebe zur Verfügung stehen.

Bekannt ist es aber auch, statt eines Gewebes einen nicht gewebten Faserstoff herzustellen, der in einer Kunststoffmatrix elektrisch leitende Fasern in nicht-regulärer Anordnung enthält (US-A-5,876,643). Durch Trocknen des Materials und Kompaktieren unter Druck und Wärme entsteht dabei jedoch ein steifes Abschirmmaterial, das sich bei der Herstellung zwar gut formen lässt, anschliessend aber seine Form unverändert beibehält.

Schliesslich ist in der eingangs genannten EP-A2-0 816 543 vorgeschlagen worden, aus einem mit einer isolierenden Lackschicht versehenen monofilen Metallfaden durch Umspinnen mit textilen Fasern ein elektrisch leitendes Verbundgarn herzustellen, das auf herkömmliche Weise zu einem elektromagnetisch abschirmenden Gewebe oder Gestrick verarbeitet werden kann. Der Isolierlack, der den feinen Metallfaden umhüllt, verstärkt dabei nicht nur die Bindung zwischen dem Faden und den ihn umgebenden textilen Fasern, sondern verbessert auch die mechanischen Eigenschaften des Metallfadens und schützt ihn gegen korrosive Angriffe von aussen. Dieser Schutz spielt insbesondere bei einer Anwendung des Gewebes im Kleidungsbereich eine Rolle, wo sonst entweder durch Schweiss, Waschlauge oder dgl. Veränderungen an der Oberfläche des Metallfadens hergerufen würden, die den Stoff verfärben und unansehnlich werden lassen können, oder der direkte Kontakt des Metalls mit der Haut Irritationen oder Allergien auslösen könnte.

Nachteilig ist bei der Verwendung eines derartigen isolierten (lackierten) Metallfadens allerdings, dass - wenn die Schutzschicht beim Verspinnen und Weben nicht verletzt wird - zwischen den verwebten Fäden kein elektrischer Kontakt besteht. Hierdurch bleibt die elektromagnetische Abschirmwirkung hinter der eines Gewebes aus blanken, sich gegenseitig kontaktierenden Drähten deutlich zurück.

### DARSTELLUNG DER ERFINDUNG

Es ist daher Aufgabe der Erfindung, einen Feindraht bzw. Feinstdraht für die Anwendung in einem Fasermaterial, insbesondere einem gewebten oder nicht-gewebten Stoff, zu schaffen, mit dem sich verbesserte Abschirmeigenschaften erreichen lassen, und der zugleich unempfindlich gegen unterschiedliche Umwelteinflüsse ist, sowie Anwendungen eines solchen Fein- bzw. Feinstdrahtes anzugeben. Die Aufgabe wird durch die Gesamtheit der Merkmale der Ansprüche 1, 14 und 15 gelöst. Der Kern der Erfindung besteht darin, den Fein- bzw. Feinstdraht aussen mit einer Schutzschicht auf organischer Basis zu umhüllen, die elektrisch leitend ausgebildet ist. Durch diese Massnahme wird gleichzeitig im fertigen Stoff ein sicherer elektrischer Kontakt zwischen den verschiedenen Drähten erreicht, und die Drähte werden gegen Umwelteinflüsse sicher geschützt. Insbesondere kann ein elektrisch leitender Schutzlack dazu verwendet werden, dem Draht ein bestimmtes farbiges Aussehen zu verleihen, das vorteilhaft zur Farbgebung des fertigen Stoffes passt.

Gemäss einer ersten bevorzugten Ausgestaltung der Erfindung besteht die Schutzschicht aus einem organischen Material, welches selbst (intrinsisch) elektrisch leitend ist, insbesondere aus einem elektrisch leitenden Polymer. Dabei kann es sich vorzugsweise um ein elektrisch leitendes Polyanilin, Polypropylen oder Polyethylendioxythiophen handeln. Derartige Polymere sind aus verschiedenen Patentschriften bekannt, z.B. aus der US-A-5,470,505 oder der EP-A1-0 767 009, oder der EP-A1-0 593 111 oder der EP-A1-0 602 713. Dem elektrisch leitenden organischen Material kann zusätzlich ein Leitsalz/Leitpolymer zur Dotierung zugesetzt werden. Dadurch lässt sich die Leitfähigkeit deutlich verbessern. Leitsalze können z.B. Sulfonate des Styrols, Polystyrols, Kampfers oder Phtalocyanins sowie Benzoldisulfonat sein. Auch anorganische Anionen wie BF₄⁻ oder ClO₄⁻ sowie Seifenzusätze kommen in Frage. Eine Verbesserung der Leitfähigkeit ist darüber hinaus durch Zusatz eines elektrisch leitenden Füllstoffes zu erreichen, wobei der Füllstoff entweder Kohlenstoff, insbesondere in Form von Russ oder Graphit, sein kann. Verwendet werden können aber auch metallische oder metallisierte Edelmetall-Partikel, insbesondere auf der Basis von Silber.

Gemäss einer zweiten bevorzugten Ausgestaltung der Erfindung besteht die umhüllende Schutzschicht aus einem elektrisch zunächst nicht leitenden organischen Grundstoff, welchem ein elektrisch leitender Füllstoff zugemischt wird. Dabei kann der Füllstoff Kohlenstoff, insbesondere in Form von Russ oder Graphit, enthalten, oder metallische und/oder metallisierte Partikel, insbesondere auf der Basis von Kupfer, Silber oder anderen Edelmetallen. Auch kann dem zunächst nicht leitenden organischen Grundstoff ein elektrisch leitendes Polymer, wie oben in der ersten Ausgestaltung beschrieben, zugemischt werden. Ein Zusatz von Leitsalz/Leitpolymer verbessert die Leitfähigkeit ebenfalls deutlich.

Der Metalldraht selbst besteht vorzugsweise aus einem Metall aus der Reihe Cu, Messing und Al. Er kann zusätzlich mit einer metallischen Beschichtung z.B. aus Silber oder Kupfer versehen sein.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in der perspektivischen, teilweise geschnittenen Darstellung einen Fein- bzw. Feinstdraht gemäss einem ersten Ausführungsbeispiel der Erfindung mit einer direkt auf den Metalldraht aufgebrachten leitenden Schutzschicht;
- Fig. 2: ein zu Fig. 1 vergleichbares Ausführungsbeispiel mit einer zusätzlichen metallischen Beschichtung zwischen Metalldraht und Schutzschicht;
- Fig. 3: die schematisierte Darstellung (Seitenansicht) eines mit textilen Fäden zu einem Garn versponnenen Fein- bzw. Feinstdrahtes nach der Erfindung; und
- Fig. 4: im Querschnitt ein Gewebe aus Feindrähten und/oder Garnen mit Feindrähten nach der Erfindung.

### WEGE ZUR AUSFÜHRUNG DER ERFINDUNG

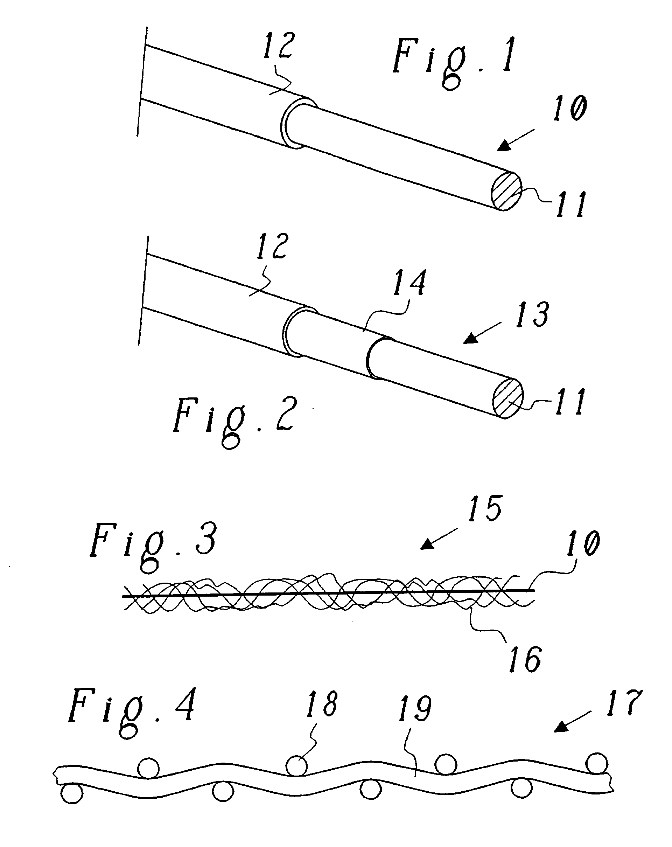

In den Fig. 1 und 2 sind in der perspektivischen, teilweise geschnittenen Darstellung jeweils ein Fein- bzw. Feinstdraht 10 und 13 gemäss einem ersten und zweiten Ausführungsbeispiel der Erfindung dargestellt. Der Fein- bzw. Feinstdraht 10 der Fig. 1 umfasst einen zentralen Metalldraht 11, der vorzugsweise aus Cu, Messing oder Al besteht, und der mit einer Schutzschicht 12 auf organischer Basis umhüllt ist. Beim Fein- bzw. Feinstdraht 13 der Fig. 2 ist zusätzlich zwischen der Schutzschicht 12 und dem Metalldraht 11 eine metallische Beschichtung 14 vorgesehen, die direkt auf den Metalldraht 11 aufgebracht ist. Die metallische Beschichtung 14 kann - insbesondere bei einem Metalldraht 11 aus Cu - aus Ag bestehen, oder - bei einem Metalldraht 11 aus Al - aus Cu. Die metallische Beschichtung 14 stellt einen zusätzlichen Schutz für den Metalldraht 11 dar und beeinflusst im Zusammenhang mit einer farbigen Schutzschicht 12 gleichzeitig die Farbgebung des Fein- bzw. Feinstdrahtes 13.

Die Schutzschicht 12 ist erfindungsgemäss als elektrisch leitende Schicht ausgebildet. Sie kann - ähnlich wie bei der herkömmlichen Herstellung von Kupferlackdrähten - durch Auftragen und Trocknen bzw. Härten eines entsprechenden flüssigen Lackes auf den Metalldraht aufgebracht werden, wobei je nach der gewünschten Schichtdicke mehrere Auftrags- und Aushärtungsvorgänge hintereinander durchgeführt werden können. Der Lackiervorgang selbst kann dabei auf unterschiedliche Weise ausgestaltet sein: So ist es denkbar, den Metalldraht 11 mehrfach an einem mit dem Lack getränkten Filz oder Schwamm vorbeizuführen. Es ist aber auch eine Tauchlackierung denkbar, bei welcher der Draht durch ein Lackbad gezogen wird. Schliesslich kann der Lack aber auch aufgesprüht werden. Andere Methoden aus der Technik der Pulverbeschichtung, bei denen auf den Einsatz einer Flüssigkeit als Lösungsmittel ganz verzichtet wird, sind ebenfalls möglich.

Die organische Schutzschicht 12 kann im Rahmen der Erfindung auf unterschiedliche Weise elektrisch leitend gemacht werden: Als Grundstoffe für die Schutzschicht kommen Polymere wie z.B. Polyurethan, Polyesterimid, Polyamidimid oder Polyimid in Betracht. Die gewünschte elektrische Leitfähigkeit kann dabei entweder eine intrinsische Eigenschaft des Grundstoffes sein, oder durch geeignete Zusatz- und/oder Füllstoffe, die in den Grundstoff eingemischt werden, hervorgerufen und eingestellt werden.

Als Beispiel für Polymere mit intrinsischen leitenden Eigenschaften sei auf das Polyanilin, Polypyrrol oder Polythiophen verwiesen, wie es in der EP-A1-0 767 009 oder der US-A-5,470,505 beschrieben ist. Die elektrisch leitfähigen Polymere können dabei in situ auf der Oberfläche des Metalldrahtes 11 erzeugt werden. Es ist aber auch denkbar, das die leitfähigen Polymere in fein dispergierter oder kolloider Form in einem herkömmlichen Lack enthalten sind. Weiterhin ist es denkbar, Polyanilin durch Zusatz von Seife zu einem elektrisch leitfähigen und gut verarbeitbaren Kunststoff zu machen. Zur Verbesserung der Leitfähigkeit können hier elektrisch leitende Füllstoffe wie Russ oder dgl. zugemischt werden.

Eine andere Möglichkeit besteht darin, einen elektrisch nicht leitfähigen Lack durch Zumischen von fein verteilten elektrisch leitenden Füllstoffen leitfähig zu machen. Als Füllstoffe kommen dabei kohlenstoffhaltige Substanzen wie Russ oder Graphit ebenso in Betracht wie metallische Pulver in Form von Ag- oder Cu-Teilchen (flakes) oder entsprechend metallisierte Teilchen (z.B. Glaskügelchen). Derartige gefüllte Leitlacke oder Leitharze sind aus der Abschirmtechnik bekannt. Als Beispiel sei in diesem Zusammenhang auf die Produkte der amerikanischen Firma Chomerics-Parker verwiesen, die unter den Namen CHO-SHIELD und CHO-FLEX angeboten werden.

Die Fein- bzw. Feinstdrähte 10, 13 haben einen Durchmesser, der vorzugsweise im Bereich von 0,015mm bis 0,200 mm liegt. Sie können als (geschnittene) leitfähige Fasern einem nicht-gewebten Faserstoff zugemischt werden und bilden dann einen durchgehend elektrisch leitenden Filz, der zu Abschirmzwecken eingesetzt werden kann. Bevorzugt werden sie jedoch in Fäden zur Herstellung von Geweben verwendet. Ein Schnitt durch ein solches Gewebe 17 ist in vereinfachter Form in Fig. 4 dargestellt. Die Kettfäden 18 und Schussfäden 19 sind dabei jeweils elektrisch leitfähige Fäden, die einen Fein- bzw. Feinstdraht 10, 13 gemäss Fig. 1 oder 2 umfassen.

Werden die Fein- bzw. Feinstdrähte 10, 13 direkt als Fäden für das Gewebe 17 verwendet, ergibt sich praktisch ein Drahtgewebe, das sich für den Einsatz im textilen Bereich (Kleidung, Gardinen etc.) nur bedingt eignet. Die Farbe des Gewebes wird dabei ausschliesslich von der Farbe der Fein- bzw. Feinstdrähte 10, 13 bestimmt. Werden die Fein- bzw. Feinstdrähte 10, 13 dagegen zunächst gemäss Fig. 3 zu einem Verbundgarn 15 verarbeitet, indem sie - wie in der EP-A2-0 816 543 beschrieben - mit textilen Fasern 16 umsponnen werden, und dann das Verbundgarn zu einem Gewebe 17 (oder Gestrick) verarbeitet, ergibt sich ein textiles Gewebe 17 (Gestrick), dessen Eigenschaften (Farbe, Waschbarkeit, mechanische Eigenschaften, Tragekomfort etc. ) massgeblich durch die textilen Fasern 16 geprägt werden, und das sich wie ein "normaler" Stoff verhält. Aus einem solchen textilen Gewebe (Gestrick) mit Abschirmeigenschaften lassen sich Kleidungsstücke mit guten Trage- und Pflegeeigenschaften fertigen. Der Stoff kann aber auch bei Heimtextilien eingesetzt oder zu Abschirmzwecken in eine Tapete oder dgl. eingearbeitet werden. Die erfindungsgemässe elektrisch leitende Schutzschicht 12 schützt dabei den Metalldraht 11 zuverlässig vor korrosiven Angriffen und dessen Folgen und verbessert gleichzeitig durch den elektrischen Kontakt zwischen den Gewebefäden die Abschirmeigenschaften. Darüber hinaus verhindert die Schutzschicht 12 unerwünschte Reaktionen bei Personen, die mit dem Gewebe in Berührung kommen.

Insgesamt ergibt sich mit der Erfindung ein Fein - bzw. Feinstdraht, der sich mit herkömmlichen Methoden leicht herstellen lässt, im Hinblick auf den Einsatz in Faserstoffen verbesserte Abschirmeigenschaften bewirkt, und zugleich gegen eine unerwünschte Wechselwirkung mit der Umgebung geschützt ist.

### BEZUGSZEICHENLISTE

- 10,13: Feindraht bzw. Feinstdraht
- 11: Metalldraht
- 12: Schutzschicht (organisch)
- 14: Beschichtung (metallisch)
- 15: Verbundgarn
- 16: textile Faser
- 17: Gewebe
- 18: Kettfaden
- 19: Schussfaden

## Patentansprüche

1. Feindraht bzw. Feinstdraht (10, 13) für die Anwendung in einem Fasermaterial, insbesondere einem gewebten oder nicht-gewebten Stoff (17), welcher Feindraht bzw. Feinstdraht (10, 13) einen Metalldraht (11) umfasst, der aussen mit einer Schutzschicht (12) auf organischer Basis umhüllt ist, **dadurch gekennzeichnet, dass** die Schutzschicht (12) elektrisch leitend ausgebildet ist.

2. Feindraht bzw. Feinstdraht nach Anspruch 1, **dadurch gekennzeichnet, dass** die Schutzschicht (12) aus einem organischen Material besteht, welches selbst elektrisch leitend ist.

3. Feindraht bzw. Feinstdraht nach Anspruch 2, **dadurch gekennzeichnet, dass** die Schutzschicht (12) aus einem elektrisch leitenden Polymer besteht.

4. Feindraht bzw. Feinstdraht nach Anspruch 3, **dadurch gekennzeichnet, dass** die Schutzschicht (12) aus einem elektrisch leitenden Polyanilin besteht.

5. Feindraht bzw. Feinstdraht nach Anspruch 2, **dadurch gekennzeichnet, dass** dem elektrisch leitenden organischen Material der Schutzschicht (12) ein elektrisch leitender Füllstoff zugemischt ist.

6. Feindraht bzw. Feinstdraht nach Anspruch 5, **dadurch gekennzeichnet, dass** der Füllstoff Kohlenstoff, insbesondere in Form von Russ oder Graphit, enthält.

7. Feindraht bzw. Feinstdraht nach Anspruch 5, **dadurch gekennzeichnet, dass** der Füllstoff metallische und/oder metallisierte Partikel, insbesondere auf der Basis von Cu oder Ag, umfasst.

8. Feindraht bzw. Feinstdraht nach Anspruch 1, **dadurch gekennzeichnet, dass** die Schutzschicht (12) aus einem elektrisch isolierenden organischen Material besteht, welchem ein elektrisch leitender Füllstoff zugemischt ist.

9. Feindraht bzw. Feinstdraht nach Anspruch 8, **dadurch gekennzeichnet, dass** der Füllstoff Kohlenstoff, insbesondere in Form von Russ oder Graphit, enthält.

10. Feindraht bzw. Feinstdraht nach Anspruch 8, **dadurch gekennzeichnet, dass** der Füllstoff metallische und/oder metallisierte Partikel, insbesondere auf der Basis von Cu oder Ag, umfasst.

11. Feindraht bzw. Feinstdraht nach Anspruch 1, **dadurch gekennzeichnet, dass** die Schutzschicht (12) aus einem elektrisch isolierenden organischen Material besteht, welches durch Zusatz eines elektrisch leitfähigen Polymers elektrisch leitend gemacht worden ist.

12. Feindraht bzw. Feinstdraht nach einem der Ansprüche 1 bis 11, **dadurch gekennzeichnet, dass** der Metalldraht (11) aus einem Metall aus der Reihe Cu, Messing und Al besteht.

13. Feindraht bzw. Feinstdraht nach Anspruch 12, **dadurch gekennzeichnet, dass** der Metalldraht (11) mit einer metallischen Beschichtung (14), vorzugsweise aus Ag oder Cu, versehen ist.

14. Anwendung des Feindrahtes bzw. Feinstdrahtes (10, 13) nach einem der Ansprüche 1 bis 13 zur Herstellung eines elektrisch leitenden Gewebes (17), **dadurch gekennzeichnet, dass** der Feindraht bzw. Feinstdraht (10, 13) als Kettfaden (18) und /oder Schussfaden (19) verwendet wird.

15. Anwendung des Feindrahtes bzw. Feinstdrahtes (10, 13) nach einem der Ansprüche 1 bis 13 zur Herstellung eines elektrisch leitenden Gewebes (17), **dadurch gekennzeichnet, dass** aus dem Feindraht bzw. Feinstdraht (10, 13) zunächst durch Umspinnen mit textilen Fasern ein Verbundgarn (15) erzeugt und anschliessend unter Verwendung des Verbundgarns (15) das Gewebe (17) hergestellt wird.

## Claims

1. Fine or superfine wire (10, 13) for use in a fibre material, especially in a woven or non-woven fabric (17), which fine or superfine wire (10, 13) comprises a metal wire (11) which is sheathed on the outside by an organic-based protective layer (12), **characterized in that** the protective layer (12) is engineered to be electrically conducting.

2. Fine or superfine wire according to Claim 1, **characterized in that** the protective layer (12) consists of an organic material which is itself electrically conducting.

3. Fine or superfine wire according to Claim 2, **characterized in that** the protective layer (12) consists of an electrically conducting polymer.

4. Fine or superfine wire according to Claim 3, **characterized in that** the protective layer (12) consists of an electrically conducting polyaniline.

5. Fine or superfine wire according to Claim 2, **characterized in that** the electrically conducting organic material of the protective layer (12) is admixed with an electrically conducting filler.

6. Fine or superfine wire according to Claim 5, **characterized in that** the filler contains carbon, especially in the form of carbon black or graphite.

7. Fine or superfine wire according to Claim 5, **characterized in that** the filler comprises metallic and/or metallized particles, especially based on Cu or Ag.

8. Fine or superfine wire according to Claim 1, **characterized in that** the protective layer (12) consists of an electrically insulating organic material which is admixed with an electrically conducting filler.

9. Fine or superfine wire according to Claim 8, **characterized in that** the filler contains carbon, especially in the form of carbon black or graphite.

10. Fine or superfine wire according to Claim 8, **characterized in that** the filler comprises metallic and/or metallized particles, especially based on Cu or Ag.

11. Fine or superfine wire according to Claim 1, **characterized in that** the protective layer (12) consists of an electrically insulating organic material which has been rendered electrically conducting by addition of an electrically conductive polymer.

12. Fine or superfine wire according to any one of Claims 1 to 11, **characterized in that** the metal wire (11) consists of a metal selected from the group consisting of Cu, brass and Al.

13. Fine or superfine wire according to Claim 12, **characterized in that** the metal wire (11) is provided with a metallic coating (14), preferably from Ag or Cu.

14. Use of the fine or superfine wire (10, 13) according to any one of Claims 1 to 13 for manufacturing an electrically conducting woven (17), **characterized in that** the fine or superfine wire (10, 13) is used as warp thread (18) and/or weft thread (19).

15. Use of the fine or superfine wire (10, 13) according to any one of Claims 1 to 13 for manufacturing an electrically conducting woven (17), **characterized in that**, in an initial step, the fine or superfine wire (10, 13) is wrap spun with textile fibres to create a composite yarn (15) and, in a subsequent step, the composite yarn (15) is used to produce the woven (17).

## Revendications

1. Fil fin ou très fin (10, 13) destiné à être utilisé dans un matériau fibreux, en particulier dans un tissu (17) tissé ou non-tissé, lequel fil fin ou très fin (10, 13) comprend un fil métallique (11) dont l'extérieur est entouré par une couche de protection (12) à base organique, **caractérisé en ce que** la couche de protection (12) est configurée de manière à être électriquement conductrice.

2. Fil fin ou très fin selon la revendication 1, **caractérisé en ce que** la couche de protection (12) est constituée d'un matériau organique qui est lui-même électriquement conducteur.

3. Fil fin ou très fin selon la revendication 2, **caractérisé en ce que** la couche de protection (12) est constituée d'un polymère électriquement conducteur.

4. Fil fin ou très fin selon la revendication 3, **caractérisé en ce que** la couche de protection (12) est constituée d'une polyaniline électriquement conductrice.

5. Fil fin ou très fin selon la revendication 2, **caractérisé en ce qu'**une charge électriquement conductrice est mélangée au matériau organique électriquement conducteur de la couche de protection (12).

6. Fil fin ou très fin selon la revendication 5, **caractérisé en ce que** la charge contient du carbone, en particulier sous la forme de suie ou de graphite.

7. Fil fin ou très fin selon la revendication 5, **caractérisé en ce que** la charge comprend des particules métalliques et/ou des particules métallisées, en particulier à base de Cu ou d'Ag.

8. Fil fin ou très fin selon la revendication 1, **caractérisé en ce que** la couche de protection (12) est constituée d'un matériau organique électriquement isolant auquel une charge électriquement conductrice est mélangée.

9. Fil fin ou très fin selon la revendication 8, **caractérisé en ce que** la charge contient du carbone, en particulier sous la forme de suie ou de graphite.

10. Fil fin ou très fin selon la revendication 8, **caractérisé en ce que** la charge comprend des particules métalliques et/ou des particules métallisées, en particulier à base de Cu ou d'Ag.

11. Fil fin ou très fin selon la revendication 1, **caractérisé en ce que** la couche de protection (12) est constituée d'un matériau organique électriquement isolant qui est rendu électriquement conducteur par addition d'un polymère électriquement conducteur.

12. Fil fin ou très fin selon l'une des revendications 1 à 11, **caractérisé en ce que** le fil métallique (11) est constitué d'un métal de la série du Cu, du laiton et de l'Al.

13. Fil fin ou très fin selon la revendication 12, **caractérisé en ce que** le fil métallique (11) est doté d'un revêtement métallique (14), de préférence en Ag ou Cu.

14. Utilisation du fil fin ou très fin (10, 13) selon l'une des revendications 1 à 13 pour la fabrication d'un tissu électriquement conducteur (17), **caractérisée en ce que** le fil fin ou très fin (10, 13) est utilisé comme fil de chaîne (18) et/ou comme fil de trame (19).

15. Utilisation du fil fin ou très fin (10, 13) selon l'une des revendications 1 à 13 pour la fabrication d'un tissu électriquement conducteur (17), **caractérisée en ce que** l'on crée d'abord un fil composite (15) par filage du fil fin ou très fin (10, 13) avec des fibres textiles, le tissu (17) étant ensuite réalisé en recourant au fil composite (15).
